# FASCICULE DE BREVET EUROPEEN

(11) **EP 0 740 425 B1**
(45) Date de publication et mention de la délivrance du brevet: **01.08.2001**
(21) Numéro de dépôt: 96410037.4
(22) Date de dépôt: 24.04.1996
(51) Int. Cl.: H03M 1/74

(54) **Convertisseur numérique/analogique de précision**
Genauigkeits-Digital-Analog-Wandler
Precision digital-to-analogue converter

(30) Priorité: 28.04.1995 FR 9505367
(43) Date de publication de la demande: 30.10.1996
(73) Titulaire: STMicroelectronics S.A., 94250 Gentilly (FR)
(72) Inventeur: Comminges, Martial, 38000 Grenoble (FR); Dell'ova, Francis, 38660 Saint Hilaire du Touvet (FR); Paillardet, Frédéric, 38000 Grenoble (FR)
(74) Mandataire: de Beaumont, Michel

(56) Documents cités:
- US-A- 4 683 458
- IEEE JOURNAL OF SOLID-STATE CIRCUITS, vol. 26, no. 12, pages 1775-1780, XP002010583 H.J.SCHOUWENAARS ET.AL.: "An Oversampled Multibit CMOS D/A Converter for Digital Audio with 115-dB Dynamic Range."

## Description

La présente invention concerne les convertisseurs numérique/analogique de précision, tels que ceux utilisés dans la restitution du son enregistré sur les disques laser.

Pour effectuer une conversion numérique/analogique avec une précision moyenne, on utilise couramment une batterie de sources de courant qui sont connectées en plus ou moins grand nombre sur une ligne de sortie commune en fonction d'une donnée numérique. Etant donné les défauts d'appariement inévitables entre les sources de courant, la précision obtenue par cette méthode ne peut dépasser 10 bits.

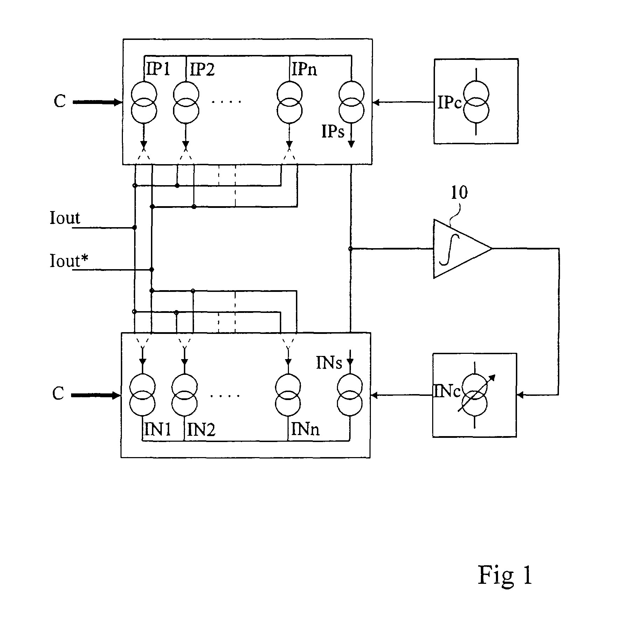

La figure 1 illustre schématiquement un convertisseur numérique/analogique permettant d'obtenir une précision plus élevée, décrit dans un article de IEEE Journal of Solid-State Circuits, vol. 16, N° 12, décembre 1991, intitulé "An Oversampled Multibit CMOS D/A Converter for Digital Audio with 115-dB Dynamic Range". Ce convertisseur comprend une batterie de sources de courant positives IP1 à IPn et une batterie de sources de courant négatives IN1 à INn. Un signal de commande numérique C sélectionne les sources de courant positives ou négatives à connecter de façon complémentaire à deux lignes de sortie différentielles Iout et Iout*. Le fonctionnement en mode différentiel permet d'améliorer certaines caractéristiques, telles que la sensibilité au bruit. Les sources de courant IP et IN sont de même valeur I, et elles sont généralement commutées de manière qu'elles soient toujours connectées à l'une ou l'autre des lignes Iout et Iout*, pour éviter du bruit de commutation.

Pour obtenir une grande précision de la conversion, chaque source IP est périodiquement étalonnée sur une source d'étalonnage IPc, et chaque source IN est périodiquement étalonnée sur une source d'étalonnage INc. La valeur d'une source IP ou IN est conservée entre deux étalonnages par effet capacitif. On assure ainsi que la valeur de chacune des sources IP est égale à la valeur de la source d'étalonnage IPc et que la valeur de chacune des sources IN est égale à la valeur de la source d'étalonnage INc.

Pour réduire la distorsion, il est nécessaire que les lignes Iout et Iout* varient de manière symétrique l'une par rapport à l'autre. Ceci entraîne que la valeur des sources IN doit être égale à la valeur des sources IP, ou encore que la valeur de la source d'étalonnage IPc soit égale à la valeur de la source d'étalonnage INc. Pour cela, les batteries de sources IP et IN comprennent chacune une source supplémentaire, respectivement IPs et INs reliées l'une à l'autre. La différence de courant entre les sources IPs et INs est prélevée par un intégrateur 10 dont la sortie réajuste la valeur de la source d'étalonnage INc jusqu'à ce que les courants des sources IPs et INs soient égaux.

Toutefois, la qualité de ce réglage de symétrie dépend de l'appariement de la source IPs avec chacune des sources IP et de l'appariement de la source INs avec chacune des sources IN. Etant donné le nombre important de sources, l'appariement est particulièrement difficile.

Un objet de la présente invention est de prévoir un convertisseur numérique/analogique de précision dans lequel le réglage de la symétrie est particulièrement précis.

Cet objet est atteint grâce à un convertiseur numérique/analogique comprenant des couples de sources de courant positives et négatives reliées par des interrupteurs à deux lignes de sortie différentielles, les interrupteurs étant commandés en fonction d'une donnée numérique. Chaque couple de sources de courant est un couple de transistors d'un étage de sortie d'un amplificateur à transconductance recevant une tension de référence sur une entrée non-inverseuse et, sur son entrée inverseuse, la tension au point milieu d'un pont de résistances connecté entre les lignes différentielles, la sortie du convertisseur étant la tension entre les deux lignes différentielles.

Selon un mode de réalisation de la présente invention, l'amplificateur à transconductance comprend un étage différentiel, le courant dans une première branche de cet étage différentiel étant recopié dans des premiers transistors des couples de transistors et le courant d'une deuxième branche de l'étage différentiel étant recopié dans les deuxièmes transistors des couples de transistors.

Selon un mode de réalisation de la présente invention, les transistors des couples des transistors sont reliés à des transistors cascode respectifs, polarisés par rapport à la tension au point milieu du pont de résistances.

Ces objets, caractéristiques et avantages ainsi que d'autres de la présente invention seront exposés en détail dans la description suivante de modes de réalisation particuliers, faite à titre non-limitatif à l'aide des figures jointes, parmi lesquelles :
la figure 1, précédemment décrite, représente schématiquement un convertisseur numérique/analogique de précision classique ;
la figure 2 représente un mode de réalisation de convertisseur numérique/analogique selon l'invention ; et
la figure 3 représente un autre mode de réalisation de convertisseur numérique/analogique selon l'invention.

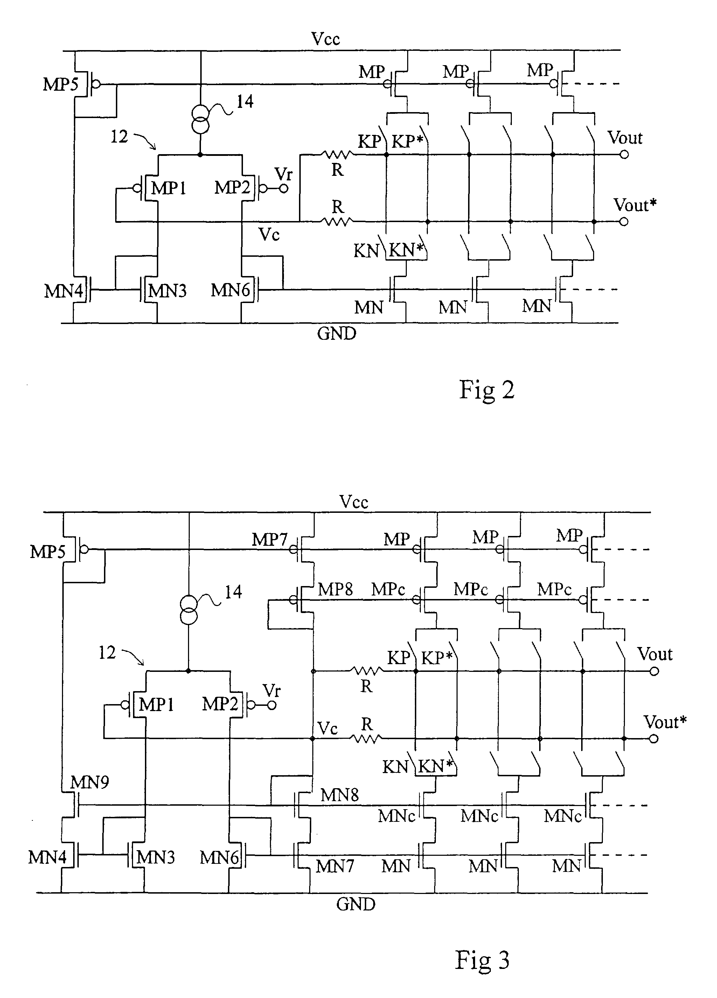

A la figure 2, une batterie de sources de courant positives est constituée par des transistors MOS à canal P MP reliés en parallèle par leurs sources et leurs grilles, les sources étant reliées à un potentiel d'alimentation haut Vcc. Une batterie complémentaire de sources de courant négatives est constituée par des transistors MOS à canal N MN reliés en parallèle par leurs sources et leurs grilles, les sources étant reliées à un potentiel d'alimentation bas GND. Le drain de chacun des transistors MP est relié à deux lignes de sortie différentielles Vout et Vout* par deux interrupteurs respectifs KP et KP*. Le drain de chacun des transistors MN est relié aux lignes Vout et Vout* par deux interrupteurs respectifs KN et KN*. Ces interrupteurs KP, KN, KP* et KN* peuvent être commandés de manière classique à partir d'une donnée numérique afin d'établir un signal différentiel analogique correspondant sur les lignes Vout et Vout*.

Selon l'invention, les transistors MP et MN forment un étage de sortie d'un amplificateur à transconductance. Cet amplificateur comprend un étage différentiel d'entrée 12 formé, par exemple, de deux transistors MOS à canal P MP1 et MP2 dont les sources sont reliées au potentiel Vcc par une source de courant de repos 14. Le courant de drain du transistor MP1, formant une première branche de l'étage 12, est recopié dans chacun des transistors MP par un premier circuit à miroir de courant. De même, le courant de drain du transistor MP2, formant une deuxième branche de l'étage 12, est recopié dans chacun des transistors MN par un deuxième circuit à miroir de courant.

Le premier circuit à miroir de courant comprend un transistor MOS à canal N MN3 dont le drain et la grille sont reliés au drain du transistor MP1, et dont la source est reliée au potentiel GND. Un transistor MOS à canal N MN4 est relié en parallèle sur le transistor MN3 par sa grille et sa source et forme avec le transistor MN3 un miroir de courant qui recopie le courant du transistor MP1 dans le transistor MN4. Le drain de ce transistor MN4 est relié au drain et à la grille d'un transistor MOS à canal P MP5 dont la source est reliée au potentiel Vcc. En outre, ce transistor MP5 est relié en parallèle par sa grille et sa source sur les transistors MP. Ainsi, les transistors MP5 et MP forment un miroir de courant qui recopie dans chacun des transistors MP le courant de drain du transistor MN4, et donc du transistor MP1.

Le deuxième circuit à miroir de courant comprend un transistor MOS à canal N MN6 dont le drain et la grille sont reliés au drain du transistor MP2. En outre, ce transistor MN6 est connecté en parallèle par sa grille et sa source sur les transistors MN et forme avec ceux-ci un miroir de courant qui recopie dans chacun des transistors MN le courant de drain du transistor MP2.

La grille du transistor MP1 constitue une entrée inverseuse de l'amplificateur à transconductance, et la grille du transistor MP2 constitue une entrée non-inverseuse. La grille du transistor MP1 reçoit la tension Vc présente au point milieu d'un pont de résistances R de même valeur relié entre les lignes de sortie différentielles Vout et Vout*.

La sortie du convertisseur selon l'invention est la tension différentielle présente aux bornes du pont de résistances R (ou entre les lignes Vout et Vout*). La grille du transistor MP2 reçoit une tension de référence Vr, qui est la tension par rapport à laquelle la sortie du convertisseur doit être symétrique.

Avec cette configuration, on réalise une structure similaire à celle d'un amplificateur à gain unitaire, en assimilant le point milieu Vc du pont de résistances R à la sortie de l'amplificateur. Ainsi, la tension Vc est régulée sur la tension de référence Vr, ce qui assure la symétrie de la tension entre les lignes Vout et Vout* par rapport à la tension Vr, quel que soit le nombre de sources MP ou MN connectées aux lignes Vout et Vout*, pourvu qu'au moins une source MP soit connectée à l'une des lignes Vout et Vout* et au moins une source MN à l'autre des lignes.

Si, par exemple, la tension Vc augmente, le courant du transistor MP1 diminue. Il en résulte, par l'intermédiaire du circuit à miroir de courant MN3, MN4 et MP5, que la conductance des transistors MP diminue, ce qui provoque la diminution de la tension Vc. Simultanément, le courant du transistor MP2 augmente symétriquement à la diminution du courant du transistor MP1. Il en résulte, par l'intermédiaire du transistor MN6, que la conductance des transistors MN augmente, ce qui tend également à diminuer la tension Vc. Ainsi, ce circuit tend effectivement à rétablir le point d'équilibre où la tension Vc est égale à la tension de référence Vr. La symétrie du signal de sortie, c'est-à-dire de la tension différentielle entre les lignes Vout et Vout*, dépend seulement du rapport des résistances R. L'appariement de seulement deux résistances peut être effectué de manière particulièrement précise, puisque les résistances R peuvent être intégrées très près l'une de l'autre.

Un convertisseur selon l'invention est particulièrement bien adapté à une méthode particulière de commutation des transistors MP et MN permettant d'obtenir la précision souhaitée, cette méthode étant notablement plus simple à mettre en oeuvre et aussi précise que la méthode d'auto-étalonnage périodique décrit en relation avec la figure 1. Il s'agit d'une méthode de commutation dite "papillon". En supposant qu'il faille connecter m transistors MP à la ligne Vout (et donc m transistors MN à la ligne Vout*), cette méthode consiste à choisir, à chaque commutation, une combinaison pseudo-aléatoire de m transistors MP et de m transistors MN parmi l'ensemble des transistors que l'on peut choisir. On obtient alors une égalisation, et donc une amélioration de la précision, par effet de moyenne. Bien entendu, les meilleurs résultats sont obtenus si ces commutations sont effectuées à une fréquence nettement supérieure à la fréquence d'échantillonnage des données numériques à convertir.

La figure 3 représente une modification du convertisseur de la figure 2, destinée à rendre le convertisseur moins sensible aux variations de sa tension d'alimentation. Chacun des transistors MP est relié à ses interrupteurs KP et KP* par l'intermédiaire d'un transistor cascode à canal P MPc. De manière similaire, chacun des transistors MN est relié à ses interrupteurs KN et KN* par l'intermédiaire d'un transistor cascode à canal N MNc. L'amplificateur comprend un étage de sortie supplémentaire destiné à polariser les transistors cascode MPc et MNc. Cet étage supplémentaire comprend un transistor MOS à canal P MP7 relié en parallèle par sa grille et sa source sur les transistors MP et un transistor MOS à canal N MN7 relié en parallèle par sa grille et sa source sur les transistors MN. Le drain du transistor MP7 est relié au point milieu du pont de résistances R par un transistor MOS à canal P MP8 dont le drain et la grille sont reliés aux grilles des transistors MPc. Le transistor MN7 est relié au point milieu du pont de résistances R par un transistor MOS à canal N MN8 dont le drain et la grille sont reliés aux grilles des transistors MNc.

Avec cette configuration, le potentiel de drain des transistors MP est fixé au potentiel Vc augmenté de la tension seuil des transistors MPc, et le potentiel de drain des transistors MN est fixé au potentiel Vc diminué de la tension seuil des transistors MNc. La tension crête sur la sortie Vout ou Vout* est ainsi limitée à la tension seuil d'un transistor MPc ou MNc, ce qui est suffisant.

L'étage de sortie supplémentaire comprenant les transistors MP7 et MN7 fonctionne dans les mêmes conditions que l'étage de sortie formé des transistors MP et MN, et n'injecte en principe aucun courant dans les résistances R. Toutefois, s'il y a un défaut de symétrie sur l'étage de sortie comprenant les transistors MP et MN, l'étage supplémentaire absorbe un courant résiduel à travers les résistances R, qui contribue à compenser le défaut de symétrie.

Un transistor cascode supplémentaire à canal N MN9 est disposé entre les transistors MN4 et MP5 et sa grille est reliée aux grilles des transistors MNc. Ce transistor cascode permet de faire fonctionner le miroir de courant MN3/MN4 dans les mêmes conditions que le miroir de courant MN6/MN, ce qui contribue à améliorer la symétrie.

## Revendications

1. Convertisseur numérique/analogique comprenant des couples de sources de courant positives (MP) et négatives (MN) reliées par des interrupteurs (KP, KN, KP*, KN*) à deux lignes de sortie différentielles (Vout, Vout*), les interrupteurs étant commandés en fonction d'une donnée numérique, caractérisé en ce que chaque couple de sources de courant est un couple de transistors d'un étage de sortie d'un amplificateur à transconductance recevant une tension de référence (Vr) sur une entrée non-inverseuse et, sur son entrée inverseuse, la tension (Vc) au point milieu d'un pont de résistances (R) connecté entre les lignes différentielles, la sortie du convertisseur étant la tension entre les deux lignes différentielles.

2. Convertisseur numérique/analogique selon la revendication 1, caractérisé en ce que l'amplificateur à transconductance comprend un étage différentiel (12), le courant dans une première branche de cet étage différentiel étant recopié dans des premiers transistors des couples de transistors et le courant d'une deuxième branche de l'étage différentiel étant recopié dans les deuxièmes transistors des couples de transistors.

3. Convertisseur numérique/analogique selon la revendication 1, caractérisé en ce que les transistors des couples des transistors sont reliés à des transistors cascode respectifs (MPc, MNc), polarisés par rapport à la tension au point milieu du pont de résistances.

## Patentansprüche

1. Digital-Analog-Wandler mit Paaren positiver (MP) und negative (MN) Stromquellen, die über Schalter (KP, KN, KP*, KN*) mit zwei Differenzausgangsleitungen (Vout, Vout*) verbunden sind, wobei die Schalter als Funktion digitaler Daten gesteuert werden, dadurch **gekennzeichnet,** daß jedes Paar der Stromquellen ein Paar Transistoren einer Ausgangsstufe eines Transkonduktanzverstärkers umfaßt, welcher eine Bezugsspannung (Vr) an einen nicht invertierenden Eingang und an einem invertierenden Eingang die Spannung (Vc) an dem Mittelknoten einer Widerstandsbrücke (R), welche zwischen den Differenzleitungen angeschlossen ist, empfängt, wobei am Ausgang des Wandlers die Spannung zwischen den zwei Differenzleitungen anliegt.

2. Digital-Analog-Wandler nach Anspruch 1, dadurch **gekennzeichnet,** daß der Transkonduktanzverstärker eine Differentialstufe (12) umfaßt, wobei der Strom in einem ersten Zweig der Differentialstufe in ersten Transistoren des Transistorpaares gespiegelt wird und der Strom eines zweiten Zweiges der Differentialstufe in den zweiten Transistoren des Transistorpaars gespiegelt wird.

3. Digital-Analog-Wandler nach Anspruch 1, dadurch **gekennzeichnet**, daß die Transistoren des Transistorpaares jeweils mit Kaskoden-Transistoren (MPc, MNc) verbunden sind, welche in bezug auf die Spannung an dem Mittelknoten der Widerstandsbrücke vorgespannt sind.

## Claims

1. A digital-to-analog converter including pairs of positive (MP) and negative (MN) current sources that are connected through switches (KP, KN, KP*, KN*) to two differential output lines (Vout, Vout*), the switches being controlled as a function of a digital data, characterized in that each pair of current sources comprises a pair of transistors of an output stage of a transconductance amplifier receiving a reference voltage (Vr) at a non-inverting input and, at an inverting input, the voltage (Vc) at the middle node of a bridge of resistors (R) connected between the differential lines, the output of the converter being the voltage between the two differential lines.

2. The digital-to-analog converter of claim 1, characterized in that the transconductance amplifier includes a differential stage (12), the current in a first branch of said differential stage being mirrored in first transistors of the pairs of transistors and the current of a second branch of the differential stage being mirrored in the second transistors of the pairs of transistors.

3. The digital-to-analog converter of claim 1, characterized in that the transistors of the pairs of transistors are connected to respective cascode transistors (MPc, MNc), biased with respect to the voltage at the middle node of the bridge of resistors.
